# EUROPÄISCHE PATENTSCHRIFT

(11) **EP 2 454 748 B1**
(45) Veröffentlichungstag und Bekanntmachung des Hinweises auf die Patenterteilung: **28.01.2015**
(21) Anmeldenummer: 10734679.3
(22) Anmeldetag: 02.07.2010
(51) Int. Cl.: H01J 23/30, H01J 25/02, H01J 37/04

(54) **VORRICHTUNG ZUR VERMEIDUNG VON PARASITÄREN SCHWINGUNGEN IN ELEKTRONENSTRAHLRÖHREN**
DEVICE FOR PREVENTING PARASITIC OSCILLATIONS IN ELECTRON BEAM TUBES
DISPOSITIF PERMETTANT D'ÉVITER LES OSCILLATIONS PARASITES DANS DES TUBES À FAISCEAU ÉLECTRONIQUE

(30) Priorität: 11.07.2009 DE 102009032759
(43) Veröffentlichungstag der Anmeldung: 23.05.2012
(73) Patentinhaber: Karlsruher Institut für Technologie, 76131 Karlsruhe (DE)
(72) Erfinder: THUMM, Manfred, 76351 Linkenheim-Hochstetten (DE); GANTENBEIN, Gerd, 76199 Karlsruhe (DE)
(74) Vertreter: Weddigen, Andreas
(86) Internationale Anmeldenummer: PCT/EP2010/003996
(87) Internationale Veröffentlichungsnummer: WO 2011/006588

(56) Entgegenhaltungen:
- FR-A1- 2 688 342
- JP-A- 11 135 028
- US-A- 2 858 472
- US-A- 3 885 192
- RZESNICKI T ET AL: "Experimental Investigations on the Pre-Prototype of the 170 GHz, 2 MW Coaxial Cavity Gyrotron for ITER" 22ND IAEA FUSION ENERGY CONFERENCE CELEBRATING FIFTY YEARS OF FUSION ENTERING INTO THE BURNING PLASMA ERA,, 13. Oktober 2008 (2008-10-13), Seiten 1-8, XP007915010
- GANTENBEIN G ET AL: "Status of development of high power coaxial-cavity gyrotrons at FZK" 5TH IAEA TECHNICAL MEETING ON ECRH PHYSICS AND TECHNOLOGY FOR LARGE FUSION DEVICES, 18 20 FEBRUARY 2009, GANDHINAGAR, INDIA,, 18. Februar 2009 (2009-02-18), Seiten 1-5, XP007915003
- MANFRED THUMM ET AL: "2.2 MW Record Power of the 0.17 THz European Pre-Prototype Coaxial-Cavity Gyrotron for ITER" TERAHERTZ SCIENCE AND TECHNOLOGY, SCINCO, INC, US, Bd. 3, Nr. 1, 1. März 2010 (2010-03-01), Seiten 1-20, XP007915004 ISSN: 1941-7411

## Beschreibung

Die Erfindung betrifft eine Vorrichtung zur Vermeidung von parasitären Schwingungen in Elektronenstrahlröhren, insbesondere im Resonator gemäß Anspruch 1.

Die genannten Elektronenstrahlröhren finden ihre Anwendung insbesondere für die berührungslose Übertragung von höheren Energiebeträgen mittels hochfrequenter elektromagnetischer Wellen wie beispielsweise bei Anwendungen mit einem Gyrotron, Magnetron, Klystron oder einer Wanderfeldröhre. Das Prinzip beruht auf einer energetischen Wechselwirkung zwischen einer Hohlleiterwelle und einem Elektronenstrahl, wobei die erzeugte hochfrequente Leistung den Elektronen in einem statischen Magnetfeld entnommen wird.

Die Elektronen werden in einem Elektronenemitter erzeugt und unter Einfluss eines elektrischen Beschleunigungsfeldes mittels einer Anode beschleunigt und durch den Strahltunnel als Strahl in einen rohrförmigen Resonator mit einem axial anliegenden statischen Magnetfeld geleitet.

Im genannten statischen Magnetfeld ist der Strahl als ElektronenHohlstrahl ausgebildet, die Elektronen bewegen sich auf wendelförmigen Bahnen. Die Umlauffrequenz wird dabei durch die Größe des Magnetfeldes und die relativische Masse der Elektronen bestimmt.

Elektronen, die unmittelbar vor dem Resonator abdriften, werden über die Innenwandungen des Strahltunnels an konzentrischen Keramikringen absorbiert und über axial abwechselnd mit den Keramikringen angeordnete konzentrische Kupferringe abgeleitet. Bei Hochvakuum-Elektronenröhren, die zur Erzeugung von Hochfrequenzstrahlung eingesetzt werden, treten häufig innerhalb des Vakuumbereichs der Röhre, insbesondere im Strahltunnel unerwünschte elektromagnetische Störschwingungen auf.
[1] beschreibt zwei verschiedene Moden von parasitären Schwingungen im Elektronenstrahl in Folge einer Anregung von Schwingungen im Strahltunnel eines Gyrotrons. Die Durchführung einer numerischen Berechung erforderte eine vereinfachte Modellbetrachtung, wobei insbesondere die Strahltunnelgeometrie idealisiert wurde.
In [2] wird zudem erwähnt, dass die elektromagnetischen Schwingungen (d.h. die parasitären Schwingungen und nicht die Elektronen) durch seitliche Öffnungen im Strahltunnel entweichen können.
[3] und [4] beschreiben weitere Modifikationen der Metallringe der Gyrotronstruktur, die die Anregung parasitärer Schwingungen in der Elektronenstrahlröhre erschweren sollen.

Grundsätzlich hat jede resonante Struktur (d.h. auch ein Strahltunnel) für eine bestimmte Schwingungsform (Mode) eine Güte Q. Diese ist durch das Verhältnis von Gesamtenergie der Schwingung zu Energieverlust pro Periode definiert. Je höher der Energieverlust eines Systems ausfällt, so geringer ist dessen Güte. Je geringer die Güte, desto einfacher lässt sich eine bestimmte Mode vermeiden.

Folglich verhindern oder erschweren die genannten parasitären elektromagnetischen Störschwingungen den Betrieb von Hochfrequenz-Elektronenstrahlröhren mit hohem Wirkungsgrad signifikant. Bei Röhren mit hoher Ausgangsleistung können diese Schwingungen zu Beschädigungen und Zerstörungen infolge thermischer Überlastung führen.

Davon ausgehend besteht die **Aufgabe der Erfindung** also darin, eine Elektronenstrahlröhre so zu modifizieren, dass in dieser die genannten Störschwingungen unterdrückt oder deren Auswirkungen auf den Elektronenstrahl reduziert werden.

Die Aufgabe wird durch einer Vorrichtung zur Vermeidung von parasitären Schwingungen in Elektronenstrahlröhren mit den Merkmalen aus Anspruch 1 gelöst; die hierauf bezogenen Unteransprüche beinhalten vorteilhafte Ausführungsformen dieser Lösungen.

Ausgehend von einem Resonator mit einem Strahltunnel mit axial anliegenden statischen Magnetfeld sowie axial abwechselnd angeordneten Keramik- und Metallringen wird zur Lösung der Aufgabe vorgeschlagen, den inneren Umfang der Metallringe im Strahltunnel mit Strukturen zu versehen. Die Strukturen sind vorzugsweise am Umfang der Bohrung in den Metallringen eingearbeitete Nuten, Einstiche oder Stufen. Die Strukturen verhindern ein störungsfreies An- und Aufschwingen dieser parasitären Schwingungsmoden. Parasitäre Schwingungen entstehen zwar, werden aber laufend und selektiv in der Ausbildung von harmonischen Schwingungen gehindert, wobei die parasitär angeregten Elektronen im wendelförmigen Elektronenstrom (Hohlstrahl) im Strahltunnel mitgerissen werden.

Ein Vorteil der Erfindung liegt in der problemlosen Nachrüstbarkeit durch einfachen Komponententausch des Strahtunnels.

Der Strahltunnel weist zwischen den Tunnelenden keine Öffnungen auf der Mantelfläche auf, die eine Ausleitung von Schwingungen oder Elektronen ermöglichen könnten. Der Strahltunnel weist dagegen eine geschlossene Form auf, innerhalb derer die parasitären Schwingungen vollständig unterdrückt und absorbiert werden. Es gelangen folglich keine hochfrequente Schwingungen außerhalb des Strahtunnels.

Die Metallringe dienen insbesondere der elektrischen Abführung von aus dem Hohlstrahl abgedrifteten Elektronen. Eine hohe elektrische Leitfähigkeit dieser Ringe ist anzustreben. Vorzugsweise sind die Metallringe aufgrund ihrer guten elektrischen Leitfähigkeit aus Kupfer gefertigt. Kupfer weist zudem eine geringe Dämpfung für HF-Wellen auf.

Die Metallringe definieren die Randbedingungen des elektromagnetischen Feldes sowie für die Bildung von parasitären Schwingungen. Weisen die Ringe an ihren inneren Umfangflächen um den Ringdurchbruch Strukturen, vorzugsweise in unregelmäßigen Abständen zueinander, wird ein Anschwingen der parasitären Schwingungen erschwert (schlechte Randbedingungen).

Die Keramikringe sind aufgrund ihres Eigenschaftsprofils vorzugsweise aus einer Oxidkeramik. Sie müssen hochvakuumtauglich, elektrisch isolierend und für eine Herstellung und der Integration in einen Resonator gut lötbar und mechanisch bearbeitbar sein. Zudem sollte das Material eine hohe Dämpfung für die parasitäre Schwingungen aufweisen.

Unregelmäßige Strukturen, vorzugsweise unregelmäßig wiederkehrende Gestaltungsmerkmale verbessern dessen Wirkung in vorteilhafter Weise und behindern die Anregung und Ausbildung von harmonischen Schwingungen zusätzlich. Vorzugsweise sind die Strukturen in unregelmäßigen Abständen, Strukturtiefen und/oder Ausgestaltung über den jeweiligen inneren Umfang des Strahltunnels verteilt. Ebenso bewirken eine unterschiedliche Anzahl und Ausgestaltung von Strukturen benachbarter Metallringe eine zusätzliche Gütereduzierung.

Weiter bevorzugt weisen Metallringe eine Anzahl entsprechend einer Primzahl von Strukturen auf. Dieser Punkt gewinnt insbesondere dann an Bedeutung, wenn die Abstände der Strukturen untereinander gleich sind und/oder multipliziert oder dividiert mit einer ganzen Zahl einer Wellenlänge einer parasitären Schwingung entsprechen. Die Reflexion möglicher parasitärer Schwingungen an den Metallringen führt zu einer unregelmäßigen Überlagerung der Schwingungen, sodass diese sich teilweise aufheben oder neutralisiert werden sowie eine Überhöhung (Resonanzeffekt) vermieden wird.

Die Erfindung wird beispielhaft anhand von Ausführungsbeispielen mit den folgenden Figuren näher erläutert. Es zeigen:
**Fig.1** eine Ausführungsformen (Grundbauformen) eines Resonators sowie der dazu gehörigen Elektronenemitter für ein Gyrotron gemäß des Stands der Technik,
**Fig.2a** **bis c** drei Ansichten eines Strahltunnels gemäß der beanspruchten Vorrichtung sowie
**Fig.3a** **bis c** beispielhafte Ausgestaltung der Strukturen auf dem inneren Umfang der Bohrung.

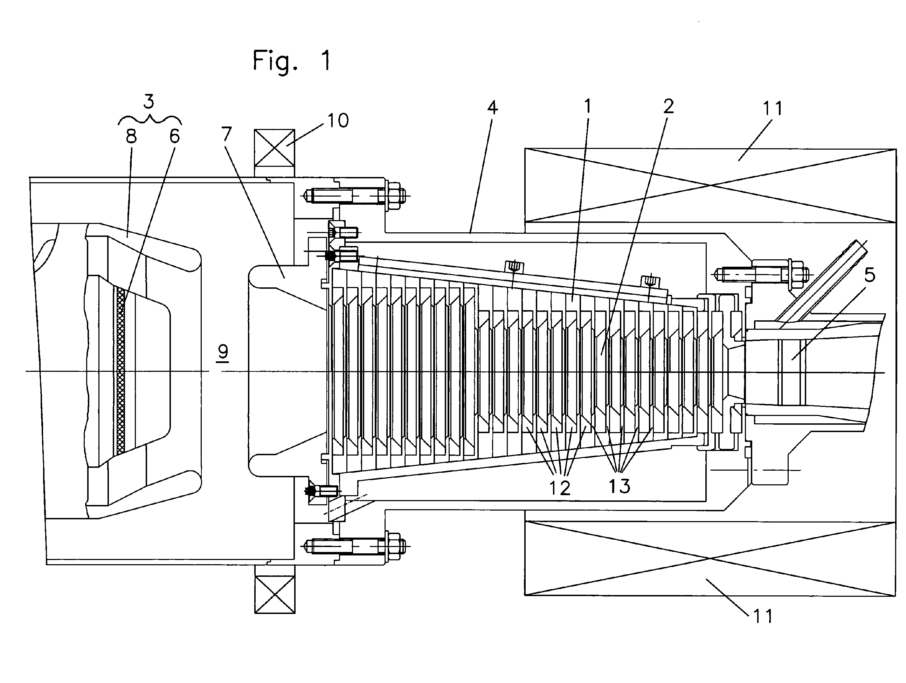

Die in **Fig.1** dargestellte Vorrichtung repräsentiert den allgemein bekannten Stand der Technik. Sie umfasst neben einem Gehäuse für einen Strahltunnel **1** mit einem konisch verjüngenden Strahltunnel 2 eine Elektronenquelle **3** zur Erzeugung eines Elektronenhohlstrahls und einem Vakuumgehäuse **4** für die Sicherstellung des erforderlichen Vakuums im Strahltunnel sowie einen Resonator **5** für die Wechselwirkung des Elektronenhohlstrahls mit der gewünschten HF-Schwingung. Die Elektronenquelle **3** umfasst einen Elektronenemitter **6** sowie eine Beschleunigungsanode **7** am Eintritt zum Strahltunnel **2,** die zum Emitter und eine um diesen angeordnete Ringelektrode **8** ein statisches elektrisches Beschleunigungsfeld **9** im Raum aufspannt. Der Strahltunnel **1** besteht im Wesentlichen aus einer Vielzahl von axial abwechselnd angeordneten Keramik- und Metallringen **12** bzw. **13** mit jeweils einem inneren Umfang der Bohrungen der Ringe um den Strahltunnel.

Die von einem Elektronenemitter **6** ausgesendeten Elektronen werden von dem Beschleunigungsfeld **9** erfasst, beschleunigt und von diesem in den Strahltunnel geleitet. Unter dem Einfluss eines statischen axialen Magnetfeldes durch eine außerhalb des Gehäuses angeordneten Magnetspulen **10** und **11** bildet sich dabei ein Elektronenhohlstrahl aus. Im Strahltunnel bewegen sich die Elektronen auf wendelörmigen Bahnen, deren Umlauffrequenz f_{HF} gegeben ist durch die Größe eines anliegenden statischen axialen Magnetfeldes erzeugt durch die Resonatormagnetspule **11** sowie durch Elektronenmasse. Anregungen eines HF-Feldes finden statt, wenn die Eigenfrequenz des Resonators geringfügig die Elektronen-Zyklotron-Frequenz f_{C} der Elektronen überschreitet.

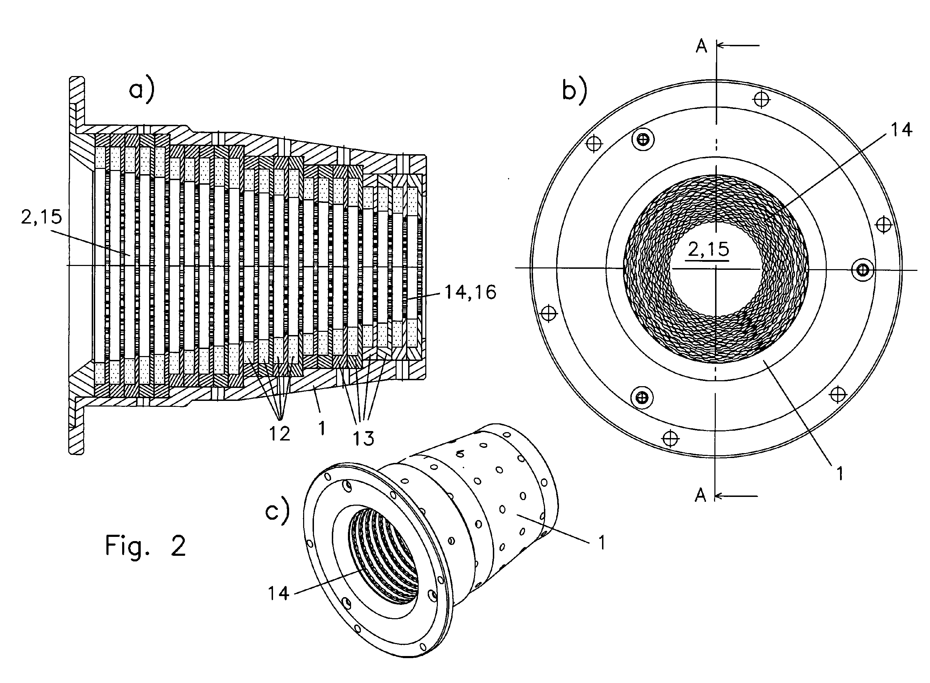

**Fig.2a** **bis c** zeigen einen Strahltunnel in seitlicher Schnittdarstellung (a), Frontansicht (b) sowie in perspektivischer Ansicht (c), der in seinem Grundaufbau mit axial abwechselnd angeordneten Keramik- und Metallringen **12** bzw. **13** mit jeweils einem inneren Umfang der Bohrungen der Ringe um den Strahltunnel in **Fig.1** ähnelt.

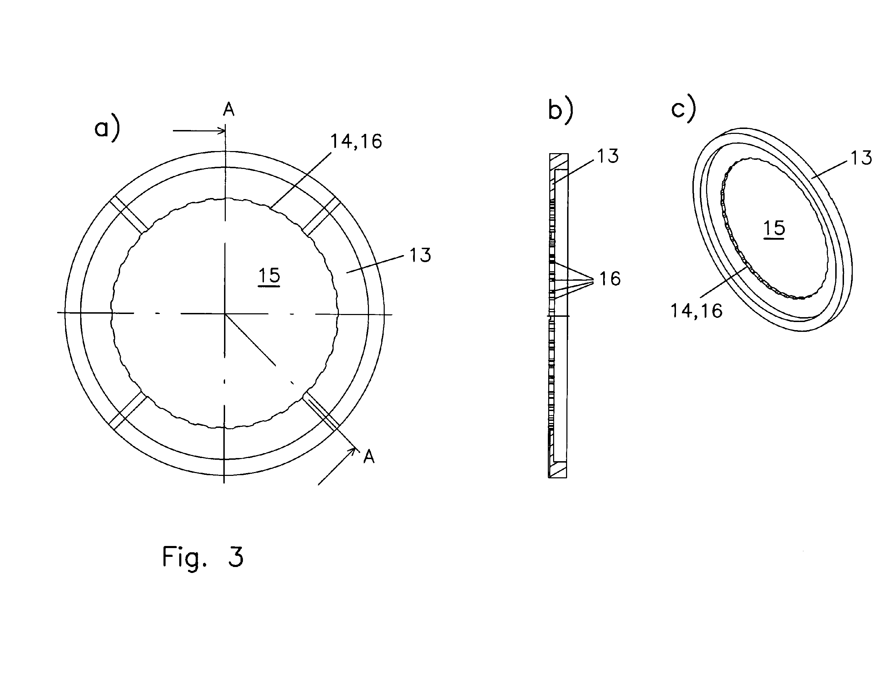

Der in **Fig.2a** **bis c** dargestellte Strahltunnel weist jedoch Strukturen der eingangs genannten Art auf dem den Strahltunnel **2** angrenzenden Umfang der Metallringe **13** auf. **Fig.3a** **bis c** zeigen einen der Metallringe in Aufsicht (a), seitlicher Schnittansicht (b) sowie in perspektivischer Darstellung. Die Struktur der an den Ringdurchbruch **15** angrenzenden Innenumfangsfläche **14** des Metallrings **13** besteht in der dargestellten Ausführungsform aus in unregelmäßigen Abständen zueinander angeordneten axial orientierten Nuten **16** (vgl. **Fig.3b****).** Diese Strukturen erstrecken sich vorzugsweise nur auf den Innnenumfang der Metallringe, während die Innenumfang der Keramikringe glatt sind.

Bevorzugte Strukturen sind vorzugsweise die genannten Nuten, aber auch Einstiche oder Stufen, die diskrete, d.h. unstetige Topographieänderungen aufweisen. Die genannten Strukturen sind bevorzugt radial nach außen gerichtet und weisen vorzugsweise keine radialen Durchgangsöffnungen am oder im Ring auf.

Bilden sich parasitäre Schwingungen in einer Resonanzfrequenz mit einer Wellenlänge λ aus, weist die Strukturtiefe der vorgenannten Nuten idealer weise einen Wert von λ/4 auf. In den Nuten reflektierende harmonische Schwingungen heben sich mit den eintreffenden Schwingungen gleicher Wellenlänge auf.

Ein unregelmäßiger Abstand der Strukturen zueinander sowie eine unterschiedliche Anzahl von Strukturen benachbarter Metallringe (vgl. **Fig.3b****)** behindern die Ausbildung von parasitären Resonanzschwingungen.

### Literatur:

[1] Tigelis et al.: IEEE Trans. Plasma Sc. Vol.26 (1998), No.3, 922-930
[2] JP 11 135 028 A
[3] RZESNICKI T ET AL: "Experimental Investigations on the Pre-Prototype of the 170 GHz, 2 MW Coaxial Cavity Gyrotron for ITER", 22ND IAEA FUSION ENERGY CONFERENCE CELEBRATING FIFTY YEARS OF FUSION ENTERING INTO THE BURNING PLASMA ERA, 13. Oktober 2008, Seiten 1-8,
GANTENBEIN G ET AL: "Status of development of high power coaxial-cavity gyrotrons at FZK", 5TH IAEA TECHNICAL MEETING ON ECRH PHYSICS AND TECHNOLOGY FOR LARGE FUSION DEVICES, 18 20 FEBRUARY 2009, GANDHINAGAR, INDIA, 18. Februar 2009, Seiten 1-5

### Bezugszeichenliste

- 1: Gehäuse für Strahltunnel
- 2: Strahltunnel
- 3: Elektronenquelle
- 4: Vakuumgehäuse
- 5: Resonator
- 6: Elektronenemitter
- 7: Beschleunigungsanode
- 8: Ringelektrode
- 9: Beschleunigungsfeld
- 10: Magnetspule
- 11: Resonatormagnetspulen
- 12: Keramikring
- 13: Metallring
- 14: Innenumfangsfläche
- 15: Ringdurchbruch
- 16: Nuten

## Patentansprüche

1. Vorrichtung zur Vermeidung von parasitären Schwingungen in Elektronenstrahlröhren, umfassend einen Strahltunnel **(2)** mit axial anliegenden statischen Magnetfeld sowie axial abwechselnd angeordneten Keramik- und Metallringen **(12, 13), dadurch gekennzeichnet, dass** die Metallringe **(13)** jeweils Nuten, Einstiche oder Stufen **(16)** am inneren Umfang **(14)** der Ringdurchbrüche **(15)** aufweisen, wobei benachbarte Metallringe **(13)** eine unterschiedliche Anzahl von Strukturen **(16)** aufweisen.

2. Vorrichtung nach Anspruch 1, wobei die Metallringe **(13)** Kupferringe sind.

3. Vorrichtung nach Anspruch 1 oder 2, wobei die Nuten, Einstiche oder Stufen **(16)** in unregelmäßigen Abständen zueinander und/oder unregelmäßigen Strukturtiefen über den jeweiligen inneren Umfang verteilt sind.

4. Vorrichtung nach einem der vorgenannten Ansprüche, wobei jeder Metallring mit Nuten, Einstiche oder Stufen eine Anzahl entsprechend einer Primzahl von Nuten, Einstiche oder Stufen **(16)** aufweist.

5. Vorrichtung nach einem der vorgenannten Ansprüche, wobei die parasitäre Schwingung eine Resonanzfrequenz mit einer Wellenlänge λ aufweist und die Strukturtiefe der Nuten, Einstiche oder Stufen λ/4 beträgt.

## Claims

1. Device for avoiding parasitic oscillations in electron beam tubes, comprising a beam tunnel (2) having a static magnetic field present in an axial manner and ceramic and metal rings (12, 13) arranged in an alternating manner axially, **characterised in that** the metal rings (13) comprise in each case grooves, recesses, or steps (16) on the inner circumference (14) of the ring apertures (15), wherein adjacent metal rings (13) comprise a different number of said structures (16).

2. Device according to claim 1, wherein the metal rings (13) are copper rings.

3. Device according to claim 1 or 2, wherein the grooves, recesses, or steps (16) are distributed at irregular intervals in relation to one another and/or irregular structure depths over the respective inner circumference.

4. Device according to any one of the preceding claims, wherein each metal ring with grooves, recesses, or steps comprises a number of grooves, recesses, or steps (16) corresponding to a prime number.

5. Device according to any one of the preceding claims, wherein the parasitic oscillation exhibits a resonance frequency with a wavelength λ and the structure depth of the grooves, recesses, or steps amounts to λ/4.

## Revendications

1. Dispositif permettant d'empêcher des oscillations parasites dans des tubes à faisceau électronique comprenant un tunnel de faisceau (2) comportant un champ magnétique statique orienté axialement ainsi que des bagues céramiques et métalliques (12, 13) montées axialement en alternance,
**caractérisé en ce que**
les bagues métalliques (13) comportent respectivement des rainures, des entailles ou des gradins (16) à la périphérie interne (14) du perçage annulaire (15), des bagues métalliques (13) voisines ayant un nombre différent de structures (16).

2. Dispositif conforme à la revendication 1, dans lequel les bagues métalliques (13) sont des bagues de cuivre.

3. Dispositif conforme à la revendication 1 ou 2, dans lequel les rainures, entailles ou gradins (16) sont réparti(e)s à des distances différentes et/ou avec des profondeurs de structure non uniformes sur la périphérie interne respective.

4. Dispositif conforme à l'une des revendications précédentes, dans lequel chaque bague métallique comportant des rainures, entailles ou gradins comporte un nombre correspondant à un nombre premier d'encoches, d'entailles ou de gradins (16).

5. Dispositif conforme à l'une des revendications précédentes, dans lequel les oscillations parasites ont une fréquence de résonnance ayant une longueur d'onde λ et la profondeur de structure des rainures, entailles ou gradins est égale à À/4.
